# EUROPÄISCHE PATENTSCHRIFT

(11) **EP 2 662 335 B1**
(45) Veröffentlichungstag und Bekanntmachung des Hinweises auf die Patenterteilung: **12.04.2017**
(21) Anmeldenummer: 13166277.7
(22) Anmeldetag: 02.05.2013
(51) Int. Cl.: C01B 33/035, C23C 16/24, C23C 16/44

(54) **POLYKRISTALLINER SILICIUMSTAB UND VERFAHREN ZU DESSEN HERSTELLUNG**
POLYCRYSTALLINE SILICON ROD AND PROCESS FOR PRODUCTION THEREOF
TIGE DE SILICIUM POLYCRISTALLIN ET SON PROCÉDÉ DE FABRICATION

(30) Priorität: 07.05.2012 DE 102012207513
(43) Veröffentlichungstag der Anmeldung: 13.11.2013
(73) Patentinhaber: Wacker Chemie AG, 81737 München (DE)
(72) Erfinder: Weber, Martin, 84556 Kastl (DE); Dornberger, Erich, 84489 Burghausen (DE); Kerscher, Michael, 84504 Burgkirchen (DE); Kraus, Heinz, 84367 Zeilarn (DE); Pech, Reiner, 84524 Neuötting (DE)
(74) Vertreter: Potten, Holger

(56) Entgegenhaltungen:
- EP-A1- 2 423 163
- EP-A2- 1 992 593

## Beschreibung

Die Erfindung betrifft einen polykristallinen Siliciumstab und ein Verfahren zur Herstellung eines polykristallinen Siliciumstabs.

Polykristallines Silicium (kurz: Polysilicium) dient als Ausgangsmaterial zur Herstellung von einkristallinem Silicium für Halbleiter nach dem Czochralski(CZ)- oder Zonenschmelz(FZ)-Verfahren, sowie zur Herstellung von ein- oder multikristallinem Silicium nach verschiedenen Zieh- und GießVerfahren zur Produktion von Solarzellen für die Photovoltaik.

Polykristallines Silicium wird in der Regel mittels des Siemens-Verfahrens hergestellt.

Bei diesem Verfahren werden in einem glockenförmigem Reaktor ("Siemens-Reaktor") Trägerkörper, üblicherweise dünne Filamentstäbe (Dünnstäbe) aus Silicium, durch direkten Stromdurchgang erhitzt und ein Reaktionsgas enthaltend Wasserstoff und eine oder mehrere Silicium enthaltende Komponenten eingeleitet.

Üblicherweise wird als Silicium enthaltende Komponente Trichlorsilan (SiHCl₃, TCS) oder eine Mischung von Trichlorsilan mit Dichlorsilan (SiH₂Cl₂, DCS) und/oder mit Tetrachlorsilan (SiCl₄, STC) eingesetzt. Auch die Verwendung von Monosilan (SiH₄) ist bekannt.

Die Dünnstäbe stecken üblicherweise senkrecht in am Reaktorboden befindlichen Elektroden, über die der Anschluss an die Stromversorgung erfolgt. Je zwei Dünnstäbe sind über eine waagrechte Brücke (ebenfalls aus Silicium) gekoppelt und bilden einen Trägerkörper für die Siliciumabscheidung. Durch die Brückenkopplung wird die typische U-Form der Trägerkörper erzeugt.

An den erhitzten Dünnstäben und der waagrechten Brücke scheidet sich hochreines Polysilicium ab, wodurch deren Durchmesser mit der Zeit anwächst.

Der Abscheideprozess wird üblicherweise durch die Vorgabe von Stabtemperatur und Reaktionsgasstrom bzw. -Zusammensetzung gesteuert.

Die Messung der Stabtemperatur erfolgt mit Strahlungspyrometern meistens an den der Reaktorwand zugewandten Oberflächen der Stäbe.

Die Stabtemperatur wird durch Steuerung oder Regelung der elektrischen Leistung entweder fest oder in Abhängigkeit vom Stabdurchmesser vorgegeben.

Die Menge und die Zusammensetzung des Reaktionsgases werden in Abhängigkeit von der Zeit oder dem Stabdurchmesser vorgegeben.

Nach dem Erreichen eines gewünschten Durchmessers wird die Abscheidung beendet und die hierbei entstandenen Polysilicium-Stäbe auf Raumtemperatur abgekühlt.

Die Morphologie des wachsenden Stabes wird von den Parametern des Abscheideprozesses bestimmt.

Die Morphologie der abgeschiedenen Stäbe kann von kompaktem und glattem bis zu sehr porösem und zerklüftetem Material variieren.

US 6,350,313 B2 offenbart die Weiterverarbeitung von kompakten polykristallinen Siliciumstäben.

Kompaktes polykristallines Silicium ist weitestgehend frei von Rissen, Poren, Fugen, Klüften usw.

Die Rohdichte eines solchen Materials entspricht der Reindichte von polykristallinem Silicium und liegt bei 2,329 g/cm³.

Aus EP 2 423 163 A1 ist polykristallines Silicium enthaltend mindestens 90 % Siliciumbruchstücke mit einer Größe zwischen 10 und 40 mm bekannt. Der Anteil an Siliciumstaubpartikeln ist gering und beträgt beispielsweise weniger als 15 ppmw für Partikelgrößen von kleiner als 400 µm. Ferner liegt die Oberflächenverunreinigung mit Metallen zwischen 0,1 und 100 ppbw.

Aus US 2003/0150378 A2 ist sogenanntes "Teardrop-Poly" und ein Verfahren zu seiner Herstellung bekannt. Bei diesem Verfahren wird aus Monosilan SiH₄ mittels des Siemens-Verfahrens bis zu einem Siliciumstabdurchmesser von 45 mm bei 850°C und einer Silankonzentration von 1,14 mol% ein kompakter, lochfreier hochreiner Polysiliciumstab abgeschieden. Anschließend wird die Staboberflächentemperatur sprungartig von 850 auf 988°C erhöht und die Silankonzentration sprungartig von 1,14 auf 0,15 mol% reduziert. Durch diesen Parametersprung ändert sich das Wachstum der Siliciumkristalle auf dem Siliciumstab schlagartig und es wachsen Nadeln, so genannte Dendriten, aus der Staboberfläche heraus. Diese Dendriten können anschließend vom kompakten Stabteil abgetrennt werden, während der kompakte Teil separat weiterverarbeitet werden muss.

US 2010/219380 A1 offenbart dagegen einen polykristallinen Siliciumstab, der eine Rohdichte im Bereich von 2,0 bis 2,3 g/cm3 und eine Gesamtporosität von 0,01 bis 0,2 aufweist. Der Siliciumstab weist eine gleichartige Struktur auf, wobei diese Struktur Poren, Fugen, Spalten, Risse und Klüfte enthält. Ein solcher polykristalliner Siliciumstab lässt sich mit geringerem Energieaufwand in Bruchstücke zerkleinern, führt demzufolge zu weniger Oberflächenkontaminationen an der Oberfläche der Bruchstücke.

Ebenso offenbart US 2010/219380 A1 ein Verfahren zur Herstellung eines Polysiliciumstabs nach einem der Ansprüche 1 bis 3, bei dem ein Mengenstrom eines Reaktionsgases enthaltend ein Chlorsilangemisch und Wasserstoff in einen Reaktor eingeleitet wird und hochreines Polysilicium an einem durch direkten Stromdurchgang erhitzten Filamentstab aus Silicium abgeschieden wird, wobei der Filamentstab aus zwei senkrechten und einem waagrechten Stab gebildet wird und wobei der waagrechte Stab eine verbindende Brücke zwischen den senkrechten Stäben bildet, dadurch gekennzeichnet, dass als Chlorsilangemisch ein Gemisch aus Di- und Trichlorsilan eingesetzt wird und der Stromdurchgang durch den Filamentstab derart geregelt ist, dass der Filamentstab eine Temperatur an der Unterseite der Brücke zwischen 1300 und 1413°C aufweist und die Temperatur der Reaktionsgase im Reaktor gemessen und so eingestellt wird, dass sie höchstens 650°C beträgt, und der Mengenstrom des Chlorsilangemisches in weniger als 30 Stunden, bevorzugt in weniger als 5 Stunden ab Beginn der Zufuhr des Chlorsilangemisches auf seinen Maximalwert eingestellt wird.

Die kompakten Stäbe sind teurer in der Produktion. Der Abscheideprozess erfolgt langsamer. Allerdings führen kompakte Stäbe in der Regel zu besseren Ausbeuten bei nachfolgenden Kristallisationsschritten.

Die Erhöhung der Grundparameter Stabtemperatur, spezifischer Durchfluss, Silan-Konzentration führt im Allgemeinen zur Erhöhung der Abscheidegeschwindigkeit und damit zu einer Verbesserung der Wirtschaftlichkeit des Abscheideprozesses. Jedem dieser Parameter sind allerdings natürliche Grenzen gesetzt, bei deren Überschreitung der Herstellungsprozess gestört wird.

Wird z.B. die Konzentration der Silicium enthaltenden Komponente zu hoch gewählt, kommt es gegebenenfalls zu homogener Gasphasenabscheidung.

Eine zu hohe Stabtemperatur kann dazu führen, dass die Morphologie der abzuscheidenden Siliciumstäbe nicht kompakt genug wird, um dem mit dem wachsenden Stabdurchmesser steigenden Stromdurchfluss eine ausreichende Querschnittfläche zur Verfügung zu stellen. Eine zu hoch werdende Stromdichte kann dabei das Schmelzen von Silicium verursachen. Ab einem gewissen Durchmesser von etwa 120 mm kann selbst bei kompakter Morphologie Silicium im Stabinneren flüssig werden, da hohen Temperaturdifferenzen zwischen Oberfläche und Stabzentrum bestehen.

Die ist auch beim Verfahren nach US 2003/0150378 A2 problematisch, da der Stromfluss ausschließlich durch den kompakten Teil des Siliciumstabs erfolgt. Wird der Durchmesser des kompakten Teils zu gering gewählt, was eigentlich erwünscht ist, da Ziel des Prozesses die Erzeugung der Dendriten ist, droht er zu schmelzen. Bei steigendem Durchmesser werden höhere Stromstärken benötigt, so dass auch der Durchmesser des kompakten Teils zunehmen muss. Das verringert die Ausbeute an Dendriten.

Bei einem polykristallinen Siliciumstab nach US 2010/219380 A1 steht dagegen ein Großteil des Stabquerschnitts für den Stromfluss zur Verfügung. Die elektrische Leitfähigkeit wird durch die kleinen Risse und Poren in Vergleich zu herkömmlichem, kompaktem Silicium nicht beeinträchtigt.

Für die meisten Anwendungen müssen polykristalline Siliciumstäbe in kleinere Bruchstücke gebrochen werden. Üblicherweise werden die Bruchstücke anschließend nach Größen klassiert. Verfahren zum Zerkleinern und Sortieren von Polysilicium ist beispielweise in US 8074905 B2 beschrieben. Dabei spielt es in der Regel keine Rolle, ob das polykristalline Silicium in kompakter oder in leicht-brüchiger Form vorliegt.

Die Morphologie polykristalliner Stäbe sowie daraus erzeugter Bruchstücke hat jedoch einen starken Einfluss auf die Performance des Produkts.

Wie zuvor erwähnt, zeigen kompakte Stäbe bessere Ausbeuten beim Kristallziehen.

Eine poröse und zerklüftete Morphologie wie nach US 2010/219380 A1 hat dagegen negative Auswirkungen auf das Kristallisationsverhalten. Besonders stark betroffen ist das anspruchsvolle CZ-Verfahren, bei welchem wegen der wirtschaftlich nicht akzeptablen Ausbeuten poröse und zerklüftete Bruchstücke bislang nicht eingesetzt werden konnten.

US 7939173 B2 offenbart einen Polysiliciumstab, der im radialen Querschnitt Bereiche mit unterschiedlichen Kristallstrukturen besitzt, wobei ein inneres Gefüge wenige oder keine Nadelkristalle umfasst und ein äußeres Gefüge Nadelkristalle und Mikrokristalle umfasst, wobei eine Mischzone vorliegt, in den das innere Gefüge fließend in das äußere Gefüge übergeht. Dieser Polysiliciumstab ist für die Anwendung im FZ-Verfahren vorgesehen. Die Herstellung erfolgt durch Abscheidung von Silicium aus mit Wasserstoff verdünnten Chlorsilanen mit einem molaren Anteil der Chlorsilane von höchstens 30%, auf einem Filamentstab aus Silicium bei einer Stabtemperatur von 950 bis 1090°C zu Beginn der Abscheidung. Zur Erzeugung der unterschiedlichen Kristallstrukturen werden die Prozessparameter fließend umgestellt. Die Stabtemperatur wird erniedrigt, die eingedüste Wasserstoffmenge reduziert, so dass der molare Anteil der Chlorsilane auf 35-60% erhöht wird.

Aus der beschriebenen Problematik ergab sich die Aufgabenstellung der vorliegenden Erfindung.

Ziel war es, polykristallines Silicium bereitzustellen, das günstiger herzustellen ist als kompaktes Material, dennoch aber eine gute Performance beim CZ-Kristallziehen zeigt.

Die Aufgabe der Erfindung wird gelöst durch einen polykristallinen Siliciumstab mit einem Durchmesser von wenigstens 150 mm, beinhaltend einen Kern (A) mit einer Porosität von 0 bis weniger als 0,01 um einen Dünnstab und mindestens zwei nachfolgende Bereiche B und C, die sich in ihrer Porosität um einen Faktor von 1,7 bis 23 unterscheiden, wobei der äußere Bereich C weniger porös ist als der Bereich B.

Vorzugsweise erstreckt sich Kern A über einen Durchmesserbereich von bis zu 60 mm. Der Dünnstab, auf dem Kern A abgeschieden ist, hat typischerweise eine Ausdehnung von wenigen mm bis zu 12 mm. Somit startet Kern A typischerweise z.B. bei einem Durchmesser von 9 mm und erstreckt sich bis zu einem Durchmesser von maximal 60 mm. Vorzugsweise erstreckt sich Kern A bis zu einem Durchmesser von maximal 50 mm, besonders bevorzugt maximal 40 mm.

Vorzugsweise weist der auf den Kern A folgende Bereich B die größte Porosität von 0,06 bis 0,23 auf und erstreckt sich über einen Durchmesserbereich von 15 % bis 90 % des Durchmessers des Siliciumstabs. Vorzugsweise erstreckt sich Bereich B über einen Durchmesserbereich von 20-80%.

Bei einem Durchmesser des Siliciumstabs von 150 mm erstreckt sich Bereich B vorzugsweise über einen Bereich von einem Durchmesser von wenigstens 22 mm bis zu einem Durchmesser von maximal 145 mm, besonders bevorzugt über einen Bereich von 45-120 mm.

Bei einem Durchmesser des Siliciumstabs von 200 mm erstreckt sich Bereich B vorzugsweise über einen Bereich von einem Durchmesser von wenigstens 30 mm bis zu einem Durchmesser von maximal 180 mm, besonders bevorzugt über einen Bereich von 40-160 mm.

Vorzugsweise weist der nachfolgende Bereich C eine geringere Porosität von 0,01 bis 0,1 auf und erstreckt sich über einen Durchmesserbereich von 50 % bis 100 % des Gesamtdurchmessers des Siliciumstabs. Vorzugsweise erstreckt sich Bereich C über einen Durchmesserbereich von 60-100%, besonders bevorzugt über einen Bereich von 70-100%.

Bei einem Durchmesser des Siliciumstabs von 150 mm erstreckt sich Bereich C vorzugsweise über einen Bereich von einem Durchmesser von wenigstens 75 mm bis zu einem Durchmesser von maximal 150 mm, besonders bevorzugt über einen Bereich von 90-150 mm, ganz besonders bevorzugt über einen Bereich von 105-150 mm.

Bei einem Durchmesser des Siliciumstabs von 200 mm erstreckt sich Bereich C vorzugsweise über einen Bereich von einem Durchmesser von wenigstens 100 mm bis zu einem Durchmesser von maximal 200 mm, besonders bevorzugt 120-200 mm, ganz besonders bevorzugt 140-200 mm.

Vorzugsweise ist die Porosität im Bereich C konstant. Besonders bevorzugt ist es, wenn die Porosität im Bereich C mit zunehmendem Durchmesser abnimmt.

Weiterhin ist es bevorzugt, wenn auf die porösen Bereiche B und C eine abschließende Schicht Z aufgebracht ist, mit einer Porosität von 0 bis weniger als 0,01 (kompakt) in einem Durchmesserbereich von 90 % bis 100 % des Gesamtdurchmessers. Ein besonders bevorzugter Durchmesserbereich beträgt 95-100%.

Bei einem Durchmesser des Siliciumstabs von 150 mm erstreckt sich Schicht Z vorzugsweise über einen Bereich von einem Durchmesser von wenigstens 135 mm bis zu 150 mm.

Bei einem Durchmesser des Siliciumstabs von 200 mm erstreckt sich Schicht Z vorzugsweise über einen Bereich von einem Durchmesser von wenigstens 180 mm bis zu 200 mm.

Vorzugsweise hat die Z-Schicht eine Dicke von wenigstens 7,5 mm.

Schicht Z ist besonders bei geringeren Durchmessern von Vorteil, wenn die Schicht C weniger dick ist, so dass eine sehr kompakte Abschlussschicht die Oberfläche glättet.

Ein Bereich des Siliciumstabs mit einer Porosität von kleiner als 0,01 wird im Rahmen der Erfindung als kompakt angesehen. Ein Bereich mit einer Porosität von 0,01 bis 0,1 wird als "dichtes Material" oder "dichte Schicht" bezeichnet. Bei Bereich C handelt es sich um dichtes Material.

Die Erfindung wird im Folgenden auch anhand von Figuren erläutert.
**Fig. 1** zeigt schematisch die Struktur eines erfindungsgemäßen Siliciumstabs, der zusätzlich eine Z-Schicht umfasst.
**Fig. 2** zeigt eine fotografische Aufnahme eines gebrochenen Siliciumstabs.

A zeigt den kompakten Kernbereich A um den Dünnstab. B stellt die erste poröse Schicht dar, C die dichte Schicht. Z bezeichnet die optionale, kompakte Schicht Z.

Die Ausdehnung der Bereiche B und C ist abhängig vom Durchmesser D des Siliciumstabs definiert.

Der Gesamtdurchmesser des polykristallinen Siliciumstabs beträgt wenigstens 150 mm.

Vorzugsweise weist der polykristalline Siliciumstab einen Gesamtdurchmesser von wenigstens 180 mm auf.

Besonders bevorzugt ist ein polykristalliner Siliciumstab mit einem Durchmesser von wenigstens 200 mm.

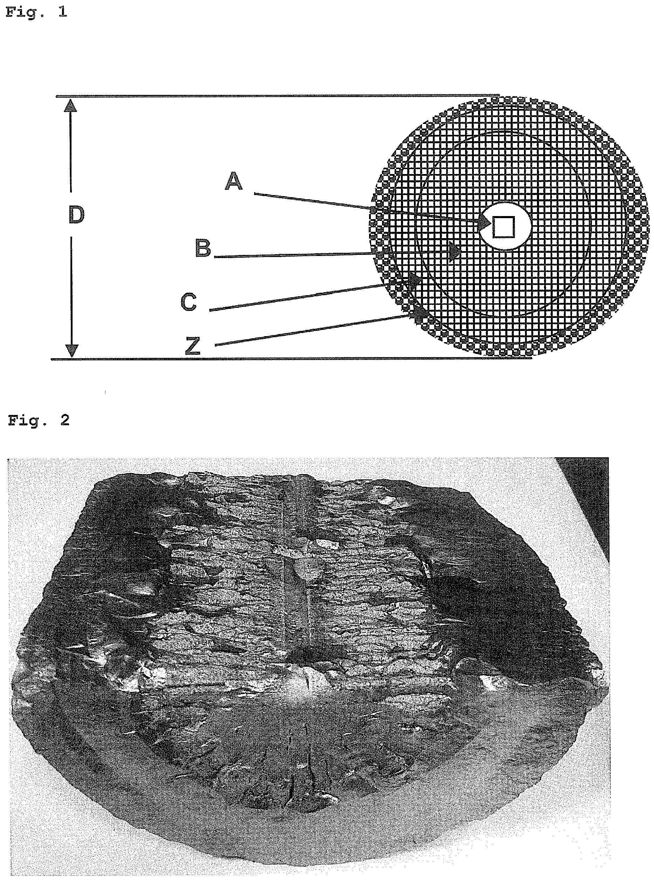

In **Fig. 2** sind ein kompakter Kern, ein poröser Bereich und ein kompakter äußerer Bereich zu erkennen.

Durch Zerkleinerung des erfindungsgemäßen polykristallinen Siliciumstabs lassen sich polykristalline Siliciumbruchstücke herstellen.

Die Zerkleinerung der Stäbe erfolgt vorzugsweise analog EP 2 423 163 A1 mit anschließendem Entstauben der Bruchstücke mittels Druckluft oder Trockeneis.

Ebenso ist es bevorzugt, die Stäbe analog US 8074905 in Bruchstücke zu brechen, in Bruchstücke von Größenklassen von etwa 0,5 mm bis größer als 45 mm zu klassieren bzw. zu sortieren und anschließend einer nasschemischen Reinigung - wie in EP 0 905 796 B1 beschrieben - zu unterziehen.

Die dabei erhaltene Menge an polykristallinen Siliciumbruchstücken zeichnet sich dadurch aus, dass sie Bruchstücke mit unterschiedlichen Porositäten bzw. Bruchstücke, die Bereiche mit unterschiedlichen Porositäten umfassen, beinhaltet.

Zudem sind Bruchstücke vorhanden, die eine Außenfläche umfassen, deren Krümmungsradius wenigstens 75 mm beträgt.

Die Porositäten einzelner Bruchstücke variieren vorzugsweise von 0 bis 0,25.

Einzelne Bruchstücke weisen eine Porosität von 0 bis weniger als 0,01 auf und stammen vom kompakten Kern des Siliciumstabs oder von der optional vorhandenen Z-Schicht.

Andere Bruchstücke sind mehr oder weniger porös und weisen Porositäten von 0,01 bis 0,25 auf.

Vorzugsweise sind Bruchstücke vorhanden, die eine Außenfläche umfassen, deren Krümmungsradius wenigstens 90 mm beträgt.

Besonders bevorzugt ist das Vorhandensein von Bruchstücken, die eine Außenfläche umfassen, deren Krümmungsradius wenigstens 100 mm beträgt.

Die Gesamtporosität einer Probe setzt sich zusammen aus der Summe der Hohlräume, die untereinander und mit der Umgebung in Verbindung stehen und den nicht miteinander verbundenen Hohlräumen. Die Gesamtporosität, d.h. der Anteil des Gesamtporenvolumens (offene und geschlossene Poren) am Gesamtvolumen des Polysiliciums wird ermittelt nach DIN-EN 1936 aus der Berechnung aus Roh- und Reindichte, d.h. Gesamtporosität = 1 - (Rohdichte/2,329[g/cm³]).

Die Rohdichte ist definiert als die Dichte des Polysiliciums einschließlich des Porenraums im trockenen Zustand nach DIN-EN 1936 (Wägung volumenmäßig definierter Prüfkörper oder Messung des Auftriebs der gesättigten Probe in Quecksilber mit einer hydrostatischen Waage).

Der kompakte Kern A des polykristallinen Siliciumstabs weist vorzugsweise eine Rohdichte von 2,329 auf (Porosität 0).

Bereich B weist vorzugsweise eine Rohdichte von 1,8 bis 2,2 auf.

Bereich C weist vorzugsweise eine Rohdichte von 2,1 bis 2,3 auf.

Schicht Z weist vorzugsweise eine Rohdichte von 2,25 bis 2,329 auf.

Die Aufgabe der Erfindung wird auch gelöst durch ein Verfahren zur Herstellung von polykristallinen Siliciumstäben durch Einleiten eines Reaktionsgases enthaltend eine Silicium enthaltende Komponente in einen Reaktor, wodurch polykristallines Silicium bis zu einem Zielstabdurchmesser auf Dünnstäben abgeschieden wird, dadurch gekennzeichnet, dass
(a) in einem ersten Schritt bis zu einem Stabdurchmesser von 15-60 mm jeweils ein Kern (A) mit einer Porosität von 0 bis weniger als 0,01 auf den Dünnstäben abgeschieden wird, wobei die Stabtemperatur 1000°C bis 1150°C beträgt, die Konzentration der Silicium enthaltenden Komponente im Reaktionsgas 20 bis 60 mol% beträgt und die Zufuhr der Silicium enthaltenden Komponente 100 bis 550 kg/h pro 1 m² Staboberfläche beträgt;
(b) in einem zweiten Schritt beginnend bei einem Stabdurchmesser von wenigstens 10% bis zu einem Stabdurchmesser von höchstens 90% des Zielstabdurchmessers eine Schicht (B) mit einer Porosität von 0,06 bis 0,23 auf Kern (A) abgeschieden wird, wobei die Stabtemperatur 1030°C bis 1130°C beträgt, die Konzentration der Silicium enthaltenden Komponente im Reaktionsgas 20 bis 40 mol% beträgt und die Zufuhr der Silicium enthaltenden Komponente 80 bis 200 kg/h pro 1 m² Staboberfläche beträgt;
(c) und in einem dritten Schritt beginnend bei einem Stabdurchmesser von wenigstens 50% bis zu einem Stabdurchmesser von höchstens 100% des Zielstabdurchmessers eine Schicht (C) mit einer Porosität von 0,01 bis 0,1 auf Schicht (B) abgeschieden wird, wobei die Stabtemperatur 960°C bis 1030°C beträgt und mindestens 20°C niedriger ist als die Stabtemperatur während des zweiten Schritts, die Konzentration der Silicium enthaltenden Komponente im Reaktionsgas 15 bis 35 mol% beträgt und die Zufuhr der Silicium enthaltenden Komponente 10 bis 130 kg/h pro 1 m² Staboberfläche beträgt.

Vorzugsweise erfolgt ein vierter Schritt beginnend bei einem Stabdurchmesser von wenigstens 90% bis zu einem Stabdurchmesser von höchstens 100% des Zielstabdurchmessers, bei dem eine Schicht (Z) mit einer Porosität von 0 bis 0,01 auf Schicht (C) abgeschieden wird, wobei die Stabtemperatur 930°C bis 1000°C beträgt und mindestens 20°C niedriger ist als die Stabtemperatur während des dritten Schritts, die Konzentration der Silicium enthaltenden Komponente im Reaktionsgas 3 bis 30 mol% beträgt und die Zufuhr der Silicium enthaltenden Komponente 6 bis 60 kg/h pro 1 m² Staboberfläche beträgt.

Der Zielstabdurchmesser beträgt vorzugsweise wenigstens 150 mm, besonders bevorzugt wenigstens 180 mm und ganz besonders bevorzugt wenigstens 200 mm.

Die Porositäten der abgeschiedenen Bereiche werden durch geeignete Wahl von Stabtemperatur und Konzentration der Silicium enthaltenden Komponente gesteuert.

Vorzugsweise wird die Zufuhr der Silicium enthaltenden Komponente im Laufe des Verfahrens reduziert. Vorzugsweise wird die Zufuhr der Silicium enthaltenden Komponente in jedem der einzelnen Verfahrensschritte innerhalb der beanspruchten Grenzen reduziert.

Vorzugsweise wird die Konzentration der Silicium enthaltenden Komponente während Schritt a) erhöht. In Schritt b) bis zur Beendigung des Verfahrens wird die Konzentration der Silicium enthaltenden Komponente vorzugsweise kontinuierlich erniedrigt.

Vorzugsweise sind die Übergänge zwischen den einzelnen Verfahrensschritten fließend. Es finden vorzugsweise keine abrupten Übergänge statt. Prozessbedingungen zu Beginn eines Verfahrensschritts entsprechen den Prozessbedingungen bei Beendigung des vorangegangenen Verfahrensschritts.

Bei der Silicium enthaltenden Komponente handelt es sich vorzugsweise um ein Chlorsilan. Vorzugsweise wird Wasserstoff als Trägergas verwendet.

Besonders bevorzugt ist die Verwendung von Trichlorsilan.

Die Konzentration des Chlorsilans im Trägergas Wasserstoff wird durch die Zufuhr von Chlorsilan und die Zufuhr von Wasserstoff geregelt.

Vorzugsweise wird die Zufuhr von Wasserstoff im Laufe des Verfahrens kontinuierlich reduziert. Vorzugsweise wird die Zufuhr von Wasserstoff in jedem der einzelnen Verfahrensschritte reduziert.

Bei der Durchführung des Verfahrens sind Prozessparameter zu überwachen. Dies erfolgt vorzugsweise wie folgt:
Gasdurchflüsse werden mit handelsüblichen Messgeräten bestimmt. Der H₂-Fluss wird mittels eines Volumendurchflussmessgeräten (z.B. einem Flügelradzähler) gemessen.

Der Durchfluss der Chlorsilane wird mittels Massendurchflussmessgeräten bestimmt.

Temperaturmessung erfolgt mit einem handelsüblichen Strahlungspyrometer, das auf etwa 1 Meter Stabhöhe die Oberflächentemperatur des nächstgelegenen Stabes misst.

Überwachung des Stabdurchmessers erfolgt mit einem optischen Messverfahren (z.B. Fernglas mit kalibrierter Strichskala, Kamera, etc.), das auf etwa 1 Meter Stabhöhe den Durchmesser eines Stabes misst oder aus den Stababständen den Durchmesser ermittelt.

Der erfindungsgemäße polykristalline Siliciumstab umfasst eine innerste Schicht bzw. einen Kernbereich A um den Dünnstab, der schnell abgeschieden wurde und kompakt ist, also definitionsgemäß eine Porosität von weniger als 0,01 aufweist. Bei der Abscheidung des kompakten Bereichs wird eine vergleichsweise niedrigere Temperatur und ein hoher Gas-Impulsstrom gewählt (Gas-Impulsstrom = Massenstrom * Austrittsgeschwindigkeit an der Düse).

Nach dem Kernbereich folgt ein erster poröser Bereich B mit einer Porosität von 0,06 bis 0,23. Auch dieser wurde schnell abgeschieden. Dieser Bereich B umfasst z.B. Löcher, Fugen und Zerklüftungen. Die Porosität wird im Wesentlichen durch Temperatur und Gasfluss bestimmt.

Auf den ersten porösen Bereich B folgt ein zweiter poröser Bereich C, der eine deutlich niedrigere Porosität von 0,01 bis 0,1 aufweist als Bereich B. Die Stabtemperatur während der Erzeugung des Bereichs C ist niedriger. Demzufolge ist dieser Bereich C langsamer abgeschieden als Bereich B. Durch Bereich C werden Löcher und Ritzen geschlossen. Die Oberfläche wird vorzugsweise eingeebnet.

Vorzugsweise umfasst der polykristalline Siliciumstab eine abschließende Schicht, um die Oberfläche des Siliciumstabs zu veredeln und eine zusätzliche Glättung der Oberfläche zu bewirken. Diese Schicht ist kompakt.

Die Vorteile der Erfindung liegen insbesondere in einem günstigeren Herstellungsprozess, zumal die überwiegenden Bereiche des Siliciumstabs (Kern A und Bereich B) schnell abgeschieden werden. So betragen die Abscheidegeschwindigkeiten (Durchmesserwachstum) für Kern A vorzugsweise 1,5 bis maximal 2 mm/h und für Bereich B 1,8 bis kleiner als 2,2 mm/h.

Die Nachteile, die poröses Material sonst aufweist und die sich vor allem in einer schlechten Performance beim Kristallziehen äußern, werden durch eine Oberflächenveredelung durch langsameres Abscheiden von wenig porösen oder kompakten äußeren Bereichen vermieden. So betragen die Abscheidegeschwindigkeiten (Durchmesserwachstum) für Bereich C vorzugsweise 1 bis weniger als 1,5 mm/h und für Schicht Z 0,7 bis weniger als 1,1 mm/h.

Das Herstellungsverfahren ist besonders wirtschaftlich, da es mit geringeren Durchsätzen an Eduktmaterial und einem geringeren Energieverbrauch verbunden ist. Prozessstörungen durch Risse, Splitter und Anlagenausfälle treten nicht auf.

Der polykristalline Siliciumstab zeigt eine hohe Ausbeute beim Kristallziehen.

So ist eine mittlere versetzungsfreie Stablänge erreichbar, die dem von kompakt abgeschiedenem Silicium entspricht.

Die Erfindung wird nun anhand von Beispielen näher erläutert.

Es sei erwähnt, dass die zu wählenden Prozessparameter vom gewählten Reaktortyp abhängen. Insbesondere die Zahl der Stäbe, der Abstand der Elektroden und die Düsendurchmesser haben Einfluss auf die Prozessbedingungen. Die nachfolgenden Beispiele beziehen sich auf einen 8 Stab-Reaktor. Bei größeren Reaktoren, z.B. einem 48 Stab-Reaktor, sind die Prozessparameter anzupassen. Anhand weniger orientierender Versuche ist es dem Fachmann möglich, die Erfindungsidee auf alle möglichen Typen von Siemens-Reaktoren zu übertragen.

Auch bei Verwendung alternativer Silicium enthaltender Komponenten - die Beispiele beziehen sich auf die Abscheidung mit Trichlorsilan und Wasserstoff als Trägergas - sind vom Fachmann entsprechende Anpassungen vorzunehmen.

### Beispiele

### Vergleichsbeispiel

Für das Vergleichsbeispiel wurde eine Abscheideanlage mit 8 Stäben und mit einem Elektrodenabstand von 270 mm verwendet. Die Gesamtstablänge (mit Brücken) betrug 20280 mm.

Der Düsendurchmesser betrug 16 mm. Als Reaktionsgas wurde ein Gemisch von Trichlorsilan und Wasserstoff verwendet.

In **Tabelle 1** sind die für das Vergleichsbeispiel gewählten Prozessparameter dargestellt. Es wurden zwei Bereiche A und B abgeschieden. D in mm gibt den wachsenden Durchmesser des Siliciumstabs an. T bezeichnet die Stabtemperatur in °C. Außerdem sind die Zufuhr an Wasserstoff und Trichlorsilan sowie die Konzentration von Trichlorsilan in mol% angegeben.

**Tabelle 1**

| **Bereich** | **D [mm]** | **T [°C]** | **H₂ [Nm³ /h / m²]** | **TCS [kg/h / m²]** | **Konz. [mol.-%]** |
|---|---|---|---|---|---|
| A | 9 | 1070 | 184 | 368 | 25 |
| A | 58 | 1070 | 51 | 150 | 33 |
| **B** | 68 | 1080 | 41 | 144 | 36 |
| **B** | 100 | 1080 | 40 | 130 | 35 |
| **B** | 130 | 1080 | 36 | 108 | 33 |
| **B** | 160 | 1068 | 28 | 80 | 32 |
| **B** | 180 | 1056 | 24 | 66 | 31 |

**Bereich A** (Kernbereich) reichte bis zum Durchmesser 58 mm und wurde mit einer Temperatur von 1070°C abgeschieden.

Die Chlorsilanmenge pro Siliciumfläche betrug 368 bis 150 kg/h/m² mit einer Molkonzentration im Trägergas (H₂) von 25 bis 33 %.

Der Kernbereich zeigte eine kompakte Morphologie ohne Löcher und Einschlüsse. Die Porosität betrug weniger als 0.01.

Zwischen 58 mm und 68 mm geht Bereich A fließend in Bereich B über.

**Bereich B** folgte im Anschluss an Schicht A bei einem Durchmesser von 68 bis 180 mm bei einer Temperatur von 1080°C bis 1056 °C.

Die Chlorsilanmenge pro Siliciumfläche betrug 144 bis 66 kg/h/m² mit einer Molkonzentration im Trägergas (H₂) von 36 bis 31 %.

Bereich B zeigte eine stark poröse Morphologie mit Löchern und Spalten. Die Porosität betrug 0,13.

Die oben beschriebenen Stäbe wurden, wie in EP 2 423 163 A1 beschrieben, in Bruchstücke gebrochen, in Bruchstücke von Größenklassen von etwa 0,5 mm bis größer als 45 mm sortiert und mittels Druckluft behandelt, um Siliciumstaub von den Bruchstücken zu entfernen. Eine chemische Nassreinigung der Bruchstücke erfolgte nicht.

Die Oberflächenmetallkontaminationen im polykristallinen Silicium sowie die Größenverteilung der einzelnen Bruchfraktionen entsprachen den in EP 2 423 163 A1 angegebenen Werten.

Aufgrund der unterschiedlichen Porosität des Stabes waren Bruchstücke mit verschiedenen Porositäten vorhanden.

Eine Probe umfassend 20 Bruchstücke unterschiedlicher Größe wurde zufällig ausgewählt und auf Porosität und (falls vorhanden) hinsichtlich des Krümmungsradius ihrer Außenfläche vermessen.

Das Ergebnis der Messungen ist in **Tabelle 2** dargestellt.

Die Polysiliciumbruchstücke aus dem Vergleichsbeispiel wurden auch hinsichtlich ihrer Performance beim Kristallziehen untersucht.

Bei 20 gemäß Vergleichsbeispiel erzeugten Stäben ergab sich eine mittlere versetzungsfreie Länge von 84 %.

Die versetzungsfreie Länge ist definiert aus versetzungsfreier Stablänge zur maximal möglichen zylindrischen, verwertbaren Stablänge.

**Tabelle 2**

| **Bruchstück** | **Masse [g]** | **Porosität** | **Krümmungsradius der Außenfläche (falls vorhanden) [mm]** |
|---|---|---|---|
| #1 | 92,6 | 0,11 | - |
| #2 | 199,3 | 0,16 | - |
| #3 | 208,0 | 0,10 | - |
| #4 | 94,7 | 0,11 | - |
| #5 | 166,4 | 0,19 | 89,1 |
| #6 | 206,0 | 0,20 | 90,25 |
| #7 | 104,6 | 0,10 | - |
| #8 | 170,0 | 0,12 | - |
| #9 | 78,0 | 0,01 | - |
| #10 | 163,0 | 0,06 | - |
| #11 | 201,2 | 0,16 | 89,5 |
| #12 | 207,6 | 0,09 | - |
| #13 | 120,1 | 0,07 | - |
| #14 | 97,7 | 0,00 | - |
| #15 | 172,5 | 0,16 | - |
| #16 | 187,5 | 0,13 | - |
| #17 | 104,2 | 0,09 | - |
| #18 | 157,1 | 0,09 | - |
| #19 | 163,4 | 0,21 | 90,95 |
| #20 | 159,0 | 0,09 | - |

### Beispiel 1

Für das erste erfindungsgemäße Beispiel wurde ebenfalls eine Abscheideanlage wie im Vergleichsbeispiel angegeben benutzt. Wie im Vergleichsbeispiel wurde mit Trichlorsilan und Wasserstoff abgeschieden.

Abweichend vom Vergleichsbeispiel wurde erfindungsgemäß ein zusätzlicher Bereich C (weniger porös als B) und eine optionale Z-Schicht (kompakt) abgeschieden.

**Tabelle 3** zeigt die verwendeten Prozessparameter.

**Tabelle 3**

| **Bereich** | **D [mm]** | **T [°C]** | H₂ **[Nm³ /h / m²]** | **TCS [kg/h / m²]** | **Konz. [mol_%]** |
|---|---|---|---|---|---|
| A | 9 | 1070 | 184 | 368 | 25 |
| A | 58 | 1070 | 51 | 150 | 33 |
| **B** | 68 | 1080 | 41 | 144 | 36 |
| **B** | 100 | 1080 | 40 | 119 | 33 |
| **B** | 121 | 1080 | 37 | 116 | 34 |
| C | 132 | 1010 | 35 | 107 | 33 |
| C | 150 | 1010 | 31 | 87 | 32 |
| C | 165 | 1010 | 30 | 66 | 27 |
| Z | 167 | 980 | 32 | 60 | 24 |
| Z | 173 | 980 | 37 | 47 | 17 |
| Z | 178 | 980 | 38 | 43 | 15 |

**Bereich A** reichte bis zum Durchmesser 58 mm und wurde mit einer Temperatur von 1070°C abgeschieden.

Die Chlorsilanmenge pro Siliziumfläche betrug 368 bis 150 kg/h/m² mit einer Molkonzentration im Trägergas (H₂) von 25 bis 33 %.

Bereich A wies eine kompakte Morphologie ohne Löcher und Einschlüsse auf. Die Porosität betrug weniger als 0,01. Zwischen 58 mm und 68 mm geht Bereich A fließend in Bereich B über.

**Bereich B** folgte im Anschluss an **Bereich** A über einen Durchmesser von 68 bis 121 mm bei einer Temperatur von 1080°C.

Die Chlorsilanmenge pro Siliziumfläche betrug 144 bis 116 kg/h/m² mit einer Molkonzentration im Trägergas (H₂) von 36 bis 34 %.

Bereich B wies eine stark poröse Morphologie auf mit Löchern und Spalten. Die Porosität betrug 0,11.

Zwischen 121 mm und 132 mm geht Bereich B fließend in Bereich C über.

**Bereich C** verläuft über den Bereich eines Durchmessers von 132 mm bis zu 165 mm.

Die Temperatur betrug dafür 1010°C.

Die Chlorsilanmenge pro Siliziumfläche betrug 107 bis 66 kg/h/m² mit einer Molkonzentration im Trägergas (H₂) von 33 bis 27 %.

Bereich C wies eine kompakte Morphologie auf mit wenig Löchern und Spalten. Die Porosität betrug 0,05.

Zwischen 165 mm und 167 mm geht Bereich C fließend in Schicht Z über.

**Schicht Z** ist die äußerste Schicht, die sich von einem Durchmesser von größer als 167 mm bis zum Zielstabdurchmesser von 178 mm erstreckt.

Die Stabtemperatur bei der Abscheidung von Schicht Z betrug 980 °C.

Die Chlorsilanmenge pro Siliziumfläche betrug 60 bis 43 kg/h/m² mit einer Molkonzentration im Trägergas (H₂) von 24 bis 15 %. Z wies eine sehr kompakte Morphologie auf ohne sichtbare Löcher und Spalten. Die Porosität betrug 0,01.

Die in Beispiel 1 erzeugten Stäbe wurden wie im Vergleichsbeispiel analog EP 2 423 163 A1 gebrochen, sortiert und entstaubt.

Eine Probe umfassend 20 Bruchstücke unterschiedlicher Größe wurde zufällig ausgewählt und hinsichtlich Porosität und (falls vorhanden) Krümmungsradius der Außenfläche vermessen.

**Tabelle 4** zeigt die Ergebnisse dieser Messungen.

Bei einigen Bruchstücken konnte der Krümmungsradius ihrer Außenfläche bestimmt werden. Dies erlaubt es, auf den Durchmesser des polykristallinen Siliciumstabs (hier: 180 mm) zu schließen.

Die Porositäten der Bruchstücke liegen im Bereich von 0 (kompakt) bis zu 0,18 (stark porös aus Bereich B).

Die Polysiliciumbruchstücke aus Beispiel 1 wurden auch hinsichtlich ihrer Performance beim Kristallziehen untersucht.

Bei 20 gemäß Beispiel 1 erzeugten Stäben ergab sich eine mittlere versetzungsfreie Länge von 98 %.

**Tabelle 4**

| **Bruchstück** | **Masse [g]** | **Porosität** | **Krümmungsradius der Außenfläche (falls vorhanden) [mm]** |
|---|---|---|---|
| #1 | 215,7 | 0,01 | 89,6 |
| #2 | 49,9 | 0,02 | - |
| #3 | 17,3 | 0,03 | - |
| #4 | 102,7 | 0,00 | 88,1 |
| #5 | 114,4 | 0,05 | - |
| #6 | 217,9 | 0,11 | - |
| #7 | 150,2 | 0,12 | - |
| #8 | 160,7 | 0,03 | - |
| #9 | 22,1 | 0,00 | 89,4 |
| #10 | 35,0 | 0,05 | - |
| #11 | 156,2 | 0,10 | - |
| #12 | 120,4 | 0,01 | 88,7 |
| #13 | 80,5 | 0,08 | - |
| #14 | 11,3 | 0,02 | 88,2 |
| #15 | 173,7 | 0,00 | 88,0 |
| #16 | 193,6 | 0,11 | - |
| #17 | 11,0 | 0,09 | - |
| #18 | 189,3 | 0,13 | - |
| #19 | 37,1 | 0,18 | - |
| #20 | 67,0 | 0,01 | 89,5 |

### Beispiel 2

Für das zweite erfindungsgemäße Beispiel wurde ebenfalls eine Abscheideanlage wie im Vergleichsbeispiel angegeben benutzt. Wie im Vergleichsbeispiel wurde mit Trichlorsilan und Wasserstoff abgeschieden.

**Tabelle 5** zeigt die Prozessbedingungen.

**Tabelle 5**

| **Schicht** | **D [mm]** | **T [°C]** | H₂ **[Nm³/h / m²]** | **TCS [kg/h / m²]** | **Konz. [mol_%]** |
|---|---|---|---|---|---|
| **A** | 9 | 1070 | 184 | 368 | 25 |
| **A** | 58 | 1070 | 51 | 150 | 33 |
| **B** | 68 | 1080 | 41 | 144 | 36 |
| **B** | 100 | 1080 | 40 | 119 | 33 |
| **B** | 132 | 1080 | 35 | 107 | 33 |
| **C** | 141 | 1010 | 33 | 97 | 33 |
| **C** | 201 | 1010 | 20 | 49 | 29 |

Anders als in Beispiel 1 wurde hier keine äußere, sehr kompakte Schicht Z abgeschieden.

**Kernbereich A** reichte bis zum Durchmesser 58 mm und wurde mit einer Temperatur von 1070°C abgeschieden.

Die Chlorsilanmenge pro Siliziumfläche betrug 368 bis 150 kg/h/m² mit einer Molkonzentration im Trägergas (H₂) von 25 bis 33 %.

Die Morphologie von Kernbereich A war kompakt ohne Löcher und Einschlüsse. Die Porosität beträgt weniger als 0,01.

Zwischen 58 mm und 68 mm geht Bereich A fließend in Bereich B über.

**Bereich B** folgte im Anschluss an Schicht A bei einem Durchmesser von 68 bis 132 mm bei einer Temperatur von 1080°C.

Die Chlorsilanmenge pro Siliziumfläche betrug 107 bis 144 kg/h/m² mit einer Molkonzentration im Trägergas (H₂) von 33 bis 36 %.

Die Morphologie von Bereich B war stark porös mit Löchern und Spalten. Die Porosität betrug 0,11.

Zwischen 132 mm und 141 mm geht Bereich B fließend in Bereich C über.

**Bereich C** ist die Abschlussschicht mit einem Durchmesser von größer oder gleich 141 mm bis zum Zielstabdurchmesser von 201 mm.

Die Temperatur betrug dafür 1010°C.

Die Chlorsilanmenge pro Siliziumfläche betrug 55 bis 97 kg/h/m² mit einer Molkonzentration im Trägergas (H₂) von 30 bis 33 %.

Die Morphologie von Bereich C ist kompakt, mit wenig Löchern und Spalten. Die Porosität betrug 0,03.

Die erzeugten Siliciumstäbe wurden - wie z.B. in US 8074905 beschrieben - in Bruchstücke gebrochen und in Bruchstücke von Größenklassen von etwa 0,5 mm bis größer als 45 mm sortiert. Sie wurden anschließend einer nasschemischen Reinigung unterzogen wie in EP 0 905 796 B1 beschrieben.

Dabei ergeben sich Oberflächenmetallkonzentrationen wie in beschrieben.

Eine Probe umfassend 20 Bruchstücke unterschiedlicher Größe wurde zufällig ausgewählt und hinsichtlich Porosität und (falls vorhanden) Krümmungsradius der Außenfläche vermessen.

**Tabelle 6** zeigt die Ergebnisse dieser Messungen.

Bei einigen Bruchstücken konnte der Krümmungsradius ihrer Außenfläche bestimmt werden. Dies erlaubt es, auf den Durchmesser des polykristallinen Siliciumstabs (hier: 201 mm) zu schließen.

Die Porositäten der Bruchstücke liegen im Bereich von 0,01 (wenig porös) bis zu 0,15 (stark porös aus Bereich B).

Die Polysiliciumbruchstücke aus Beispiel 2 wurden auch hinsichtlich ihrer Performance beim Kristallziehen untersucht.

Bei 20 gemäß Beispiel 2 erzeugten Stäben ergab sich eine mittlere versetzungsfreie Länge von 97 %.

**Tabelle 6**

| Bruchstück | Masse [g] | Porosität | Krümmungsradius der Außenfläche[mm] |
|---|---|---|---|
| #1 | 86,2 | 0,02 | 102,9 |
| #2 | 92,4 | 0,08 | - |
| #3 | 138,6 | 0,10 | - |
| #4 | 137,8 | 0,01 | 101,1 |
| #5 | 235,9 | 0,02 | 103,0 |
| #6 | 236,8 | 0,02 | - |
| #7 | 223,7 | 0,08 | - |
| #8 | 208,9 | 0,09 | - |
| #9 | 195,2 | 0,01 | - |
| #10 | 178,4 | 0,02 | - |
| #11 | 40,9 | 0,01 | 102,8 |
| #12 | 118,9 | 0,14 | - |
| #13 | 182,1 | 0,15 | - |
| #14 | 230,2 | 0,13 | - |
| #15 | 59,4 | 0,09 | - |
| #16 | 135,8 | 0,02 | 97,7 |
| #17 | 54,7 | 0,10 | - |
| #18 | 224,0 | 0,00 | 97,8 |
| #19 | 64,0 | 0,02 | 104,7 |
| #20 | 224,5 | 0,09 | - |

## Patentansprüche

1. Polykristalliner Siliciumstab, mit einem Gesamtdurchmesser von wenigstens 150 mm, beinhaltend einen Kern (A) mit einer Porosität von 0 bis weniger als 0,01 um einen Dünnstab und mindestens zwei nachfolgende Bereiche B und C, die sich in ihrer Porosität um einen Faktor von 1,7 bis 23 unterscheiden, wobei der äußere Bereich C weniger porös ist als der Bereich B.

2. Polykristalliner Siliciumstab nach Anspruch 1, wobei sich Kern A bis zu einem Durchmesser von maximal 60 mm erstreckt.

3. Polykristalliner Siliciumstab nach Anspruch 1 oder 2, wobei Bereich B eine Porosität von 0,06 bis 0,23 aufweist und sich über einen Bereich von 15 % des Gesamtdurchmessers bis maximal 90 % des Gesamtdurchmessers erstreckt.

4. Polykristalliner Siliciumstab nach einem der Ansprüche 1 bis 3, wobei Bereich C eine Porosität von 0,01 bis 0,1 aufweist und sich über einen Bereich von wenigstens 50 % des Gesamtdurchmessers bis maximal 100 % des Gesamtdurchmessers erstreckt, wobei Bereich C eine geringere Porosität als Bereich B hat.

5. Polykristalliner Siliciumstab nach einem der Ansprüche 1 bis 4, der nach Bereich C eine Schicht Z umfasst, die eine Porosität von 0 bis weniger als 0,01 aufweist und sich über einen Bereich von wenigstens 90% des Gesamtdurchmessers bis 100 % des Gesamtdurchmessers erstreckt.

6. Polykristalline Siliciumbruchstücke, hergestellt durch Zerkleinern eines polykristallinen Siliciumstabs nach einem der Ansprüche 1 bis 5.

7. Polykristalline Siliciumbruchstücke nach Anspruch 6, enthaltend Bruchstücke mit unterschiedlichen Porositäten sowie Bruchstücke, die eine gekrümmte Oberfläche mit einem Krümmungsradius von wenigstens 75 mm aufweisen.

8. Verfahren zur Herstellung von polykristallinen Siliciumstäben durch Einleiten eines Reaktionsgases enthaltend eine Silicium enthaltende Komponente in einen Reaktor, wodurch polykristallines Silicium bis zu einem Zielstabdurchmesser auf Dünnstäben abgeschieden wird, , **dadurch gekennzeichnet, dass** (a) in einem ersten Schritt bis zu einem Stabdurchmesser von 15-60 mm jeweils ein Kern (A) mit einer Porosität von 0 bis weniger als 0,01 auf den Dünnstäben abgeschieden wird, wobei die Stabtemperatur 1000°C bis 1150°C beträgt, die Konzentration der Silicium enthaltenden Komponente im Reaktionsgas 20 bis 60 mol% beträgt und die Zufuhr der Silicium enthaltenden Komponente 100 bis 550 kg/h pro 1 m² Staboberfläche beträgt; (b) in einem zweiten Schritt beginnend bei einem Stabdurchmesser von wenigstens 10% bis zu einem Stabdurchmesser von höchstens 90% des Zielstabdurchmessers eine Schicht (B) mit einer Porosität von 0,06 bis 0,23 auf Kern (A) abgeschieden wird, wobei die Stabtemperatur 1030°C bis 1130°C beträgt, die Konzentration der Silicium enthaltenden Komponente im Reaktionsgas 20 bis 40 mol% beträgt und die Zufuhr der Silicium enthaltenden Komponente 80 bis 200 kg/h pro 1 m² Staboberfläche beträgt; (c) und in einem dritten Schritt beginnend bei einem Stabdurchmesser von wenigstens 50% bis zu einem Stabdurchmesser von höchstens 100% des Zielstabdurchmessers eine Schicht (C) mit einer Porosität von 0, 01 bis 0,1 auf Schicht (B) abgeschieden wird, wobei die Stabtemperatur 960°C bis 1030°C beträgt und mindestens 20°C niedriger ist als die Stabtemperatur während des zweiten Schritts, die Konzentration der Silicium enthaltenden Komponente im Reaktionsgas 15 bis 35 mol% beträgt und die Zufuhr der Silicium enthaltenden Komponente 10 bis 130 kg/h pro 1 m² Staboberfläche beträgt.

9. Verfahren nach Anspruch 8, wobei in einem vierten Schritt, beginnend bei einem Stabdurchmesser von wenigstens 90% bis zu einem Stabdurchmesser von höchstens 100% des Zielstabdurchmessers, eine Schicht (Z) mit einer Porosität von 0 bis weniger als 0,01 auf Schicht (C) abgeschieden wird, wobei die Stabtemperatur 930°C bis 1000°C beträgt und mindestens 20°C niedriger ist als die Stabtemperatur während des dritten Schritts, die Konzentration der Silicium enthaltenden Komponente im Reaktionsgas 3 bis 30 mol% beträgt und die Zufuhr der Silicium enthaltenden Komponente 6 bis 60 kg/h pro 1 m² Staboberfläche beträgt.

10. Verfahren nach Anspruch 8 oder nach Anspruch 9, wobei in einem weiteren Verfahrensschritt die polykristallinen Siliciumstäbe zu polykristallinen Siliciumbruchstücken zerkleinert werden.

## Claims

1. Polycrystalline silicon rod having a total diameter of at least 150 mm, comprising a core (A) having a porosity of 0 to less than 0.01 around a thin rod, and at least two subsequent regions B and C which differ in porosity by a factor of 1.7 to 23, the outer region C being less porous than region B.

2. Polycrystalline silicon rod according to Claim 1, wherein core A extends up to a diameter of not more than 60 mm.

3. Polycrystalline silicon rod according to Claim 1 or 2, wherein region B has a porosity of 0.06 to 0.23 and extends over a region of 15% of the total diameter to a maximum of 90% of the total diameter.

4. Polycrystalline silicon rod according to any of Claims 1 to 3, wherein region C has a porosity of 0.01 to 0.1 and extends over a region of at least 50% of the total diameter to a maximum of 100% of the total diameter, region C having a lower porosity than region B.

5. Polycrystalline silicon rod according to any of Claims 1 to 4 which, after region C, comprises a layer Z which has a porosity of 0 to less than 0.01 and extends over a region of at least 90% of the total diameter to 100% of the total diameter.

6. Polycrystalline silicon chunks produced by comminuting a polycrystalline silicon rod according to any of Claims 1 to 5.

7. Polycrystalline silicon chunks according to Claim 6, comprising chunks with different porosities and chunks having a curved surface with a radius of curvature of at least 75 mm.

8. Process for producing polycrystalline silicon rods by introducing a reaction gas comprising a silicon-containing component into a reactor, as a result of which polycrystalline silicon is deposited on thin rods up to a target rod diameter, which comprises (a) in a first step, depositing a core (A) having a porosity of 0 to less than 0.01 onto each of the thin rods up to a rod diameter of 15-60 mm, the rod temperature being 1000°C to 1150°C, the concentration of the silicon-containing component in the reaction gas being 20 to 60 mol% and the feed rate of the silicon-containing component being 100 to 550 kg/h per 1 m² of rod surface area; (b) in a second step, beginning at a rod diameter of at least 10% up to a rod diameter of at most 90% of the target rod diameter, depositing a layer (B) having a porosity of 0.06 to 0.23 onto core (A), the rod temperature being 1030°C to 1130°C, the concentration of the silicon-containing component in the reaction gas being 20 to 40 mol% and the feed rate of the silicon-containing component being 80 to 200 kg/h per 1 m² of rod surface area; (c) and, in a third step, beginning at a rod diameter of at least 50% up to a rod diameter of at most 100% of the target rod diameter, depositing a layer (C) having a porosity of 0.01 to 0.1 onto layer (B), the rod temperature being 960°C to 1030°C and being at least 20°C lower than the rod temperature during the second step, the concentration of the silicon-containing component in the reaction gas being 15 to 35 mol%, and the feed rate of the silicon-containing component being 10 to 130 kg/h per 1 m² of rod surface area.

9. Process according to Claim 8, wherein, in a fourth step, beginning at a rod diameter of at least 90% up to a rod diameter of at most 100% of the target rod diameter, a layer (Z) having a porosity of 0 to less than 0.01 is deposited onto layer (C), the rod temperature being 930°C to 1000°C and being at least 20°C lower than the rod temperature during the third step, the concentration of the silicon-containing component in the reaction gas being 3 to 30 mol%, and the feed rate of the silicon-containing component being 6 to 60 kg/h per 1 m² of rod surface area.

10. Process according to Claim 8 or according to Claim 9, wherein, in a further process step, the polycrystalline silicon rods are comminuted to polycrystalline silicon chunks.

## Revendications

1. Barre de silicium polycristallin présentant un diamètre total d'au moins 150 mm, comprenant un noyau (A) présentant une porosité de 0 à moins de 0,01 autour d'une barre mince et au moins deux zones consécutives B et C, qui se distinguent, en ce qui concerne leur porosité, d'un facteur de 1,7 à 23, la zone externe C étant moins poreuse que la zone B.

2. Barre de silicium polycristallin selon la revendication 1, le noyau A s'étendant jusqu'à un diamètre d'au maximum 60 mm.

3. Barre de silicium polycristallin selon la revendication 1 ou 2, la zone B présentant une porosité de 0,06 à 0,23 et s'étendant sur une zone de 15% du diamètre total jusqu'au maximum 90% du diamètre total.

4. Barre de silicium polycristallin selon l'une quelconque des revendications 1 à 3, la zone C présentant une porosité de 0,01 à 0,1 et s'étendant sur une zone d'au moins 50% du diamètre total jusqu'au maximum 100% du diamètre total, la zone C présentant une porosité inférieure à celle de la zone B.

5. Barre de silicium polycristallin selon l'une quelconque des revendications 1 à 4, qui comprend, après la zone C, une couche Z, qui présente une porosité de 0 à moins de 0,01 et qui s'étend sur une zone d'au moins 90% du diamètre total jusqu'à 100% du diamètre total.

6. Fragments de silicium polycristallin, préparés par concassage d'une barre de silicium polycristallin selon l'une quelconque des revendications 1 à 5.

7. Fragments de silicium polycristallin selon la revendication 6, contenant des fragments présentant des porosités différentes ainsi que des fragments qui présentent une surface incurvée présentant un rayon de courbure d'au moins 75 mm.

8. Procédé pour la préparation de barres de silicium polycristallin par introduction d'un gaz de réaction, contenant un composant contenant du silicium, dans un réacteur, suite à quoi du silicium polycristallin est déposé sur des barres minces jusqu'à un diamètre cible de la barre, **caractérisé en ce que** (a) dans une première étape, on dépose, jusqu'à un diamètre de barre de 15-60 mm, à chaque fois un noyau (A) présentant une porosité de 0 à moins de 0,01 sur des barres minces, la température de la barre étant de 1000°C à 1150°C, la concentration en composant contenant du silicium dans le gaz de réaction étant de 20 à 60% en mole et l'alimentation en composant contenant du silicium étant de 100 à 550 kg/h par 1 m² de surface de la barre ; (b) dans une deuxième étape, démarrant à un diamètre de barre d'au moins 10% jusqu'à un diamètre de barre d'au plus 90% du diamètre cible de la barre, on dépose une couche (B) présentant une porosité de 0,06 à 0,23 sur le noyau (A), la température de la barre étant de 1030°C à 1130°C, la concentration en composant contenant du silicium dans le gaz de réaction étant de 20 à 40% en mole et l'alimentation en composant contenant du silicium étant de 80 à 200 kg/h par 1 m² de surface de la barre ; (c) et dans une troisième étape, démarrant à un diamètre de barre d'au moins 50% jusqu'à un diamètre de barre d'au plus 100% du diamètre cible de la barre, on dépose une couche (C) présentant une porosité de 0,01 à 0,1 sur la couche (B), la température de la barre étant de 960°C à 1030°C et inférieure d'au moins 20°C à la température de la barre pendant la deuxième étape, la concentration en composant contenant du silicium dans le gaz de réaction étant de 15 à 35% en mole et l'alimentation en composant contenant du silicium étant de 10 à 130 kg/h par 1 m² de surface de la barre.

9. Procédé selon la revendication 8, dans lequel, dans une quatrième étape, démarrant à un diamètre de barre d'au moins 90% jusqu'à un diamètre de barre d'au plus 100% du diamètre cible de la barre, on dépose une couche (Z) présentant une porosité de 0 à moins de 0,01 sur la couche (C), la température de la barre étant de 930°C à 1000°C et inférieure d'au moins 20°C à la température de la barre pendant la troisième étape, la concentration en composant contenant du silicium dans le gaz de réaction étant de 3 à 30% en mole et l'alimentation en composant contenant du silicium étant de 6 à 60 kg/h par 1 m² de surface de la barre.

10. Procédé selon la revendication 8 ou selon la revendication 9, les barres en silicium polycristallin étant concassées en fragments de silicium polycristallin dans une autre étape de procédé.
